# EUROPEAN PATENT SPECIFICATION

(11) **EP 2 287 232 B1**
(45) Date of publication and mention of the grant of the patent: **01.08.2018**
(21) Application number: 09758349.6
(22) Date of filing: 03.06.2009
(51) Int. Cl.: C08J 3/02, G02B 1/04, B01J 13/00

(54) **COLLOIDAL CRYSTALLINE GEL, METHOD FOR PRODUCING SAME AND OPTICAL ELEMENT WHEREIN SAME IS USED**
KOLLOIDKRISTALLGEL, VERFAHREN ZU SEINER HERSTELLUNG UND OPTISCHES ELEMENT ZU SEINER VERWENDUNG
GEL CRISTALLIN COLLOÏDAL, PROCÉDÉ POUR PRODUIRE CELUI-CI ET ÉLÉMENT OPTIQUE DANS LEQUEL CELUI-CI EST UTILISÉ

(30) Priority: 04.06.2008 JP 2008146827
(43) Date of publication of application: 23.02.2011
(73) Proprietor: National Institute for Materials Science, Tsukuba-shi, Ibaraki 305-0047 (JP)
(72) Inventor: SAWADA, Tsutomu, Tsukuba-shi Ibaraki 305-0047 (JP); KANAI, Toshimitsu, Tsukuba-shi Ibaraki 305-0047 (JP); ITO, Kensaku, Tsukuba-shi Ibaraki 305-0047 (JP)
(74) Representative: Vossius & Partner Patentanwälte Rechtsanwälte mbB
(86) International application number: PCT/JP2009/060156
(87) International publication number: WO 2009/148082

(56) References cited:
- JP-A- 2006 124 521
- JP-A- 2006 162 673
- JP-A- 2007 219 067
- US-A1- 2002 164 823
- US-A1- 2007 121 193
- DATABASE WPI Week 200820 Thomson Scientific, London, GB; AN 2008-C70845 XP002717284, -& JP 2008 046359 A (FUJI XEROX CO LTD) 28 February 2008 (2008-02-28)
- DATABASE WPI Week 200801 Thomson Scientific, London, GB; AN 2008-A06526 XP002717285, & JP 2007 297421 A (UNIV YOKOHAMA NAT) 15 November 2007 (2007-11-15)
- DATABASE WPI Week 200654 Thomson Scientific, London, GB; AN 2006-526141 XP002717286, & JP 2006 208453 A (TOYOTA CHUO KENKYUSHO KK) 10 August 2006 (2006-08-10)

## Description

### FIELD OF THE INVENTION

The present invention relates to a colloidal crystal gel in which fine particles are self-organizingly and periodically lined up in a polymer gel, its production process, and an optical device using the same.

### BACKGROUND OF THE INVENTION

With regard to a fine particle dispersion liquid having fine particles dispersed in a liquid medium, it has been known that the fine particles (colloidal particles) in the fine particle dispersion liquid are self-organizing and periodically lined up as they have high monodispersion capability and a volume fraction greater than a given value. The fine particle dispersion liquid in such a state is called a colloidal crystal. The colloidal crystal, because of developing specific properties (formation of photonic band gaps, anomalous dispersion of light group velocity, etc.) based on Bragg reflection for electromagnetic wave, is now expected to have potential applications to optical devices harnessing the nature of photonic crystals.

There has also been a colloidal crystal gel or gelled colloidal crystal known, in which the positions of fine particles in the colloidal crystal are fixed by a polymer gel composed of a network polymer and a liquid medium thereby preventing the particles from being out of array due to environmental disturbances such as vibrations and temperature changes. The inventors have already developed a colloidal crystal gel in particular, using an organic solvent as the liquid medium (for instance, see JP(A) 2006-124521).

According to JP(A) 2006-124521, the polyhydric alcohol used as the organic solvent is soluble in water, with its volatility lower than that of water. It is thus possible to provide a colloidal crystal gel that remains stable over an extended period of time with no shrinkage of the polymer gel and with minimized changes in the lattice constant of the colloidal crystal gel caused by the evaporation of water. It is also possible to use two or more solvents as the solvent thereby regulating the swelling degree of the gel texture in inter-particle structure and, hence, providing colloidal crystal gels having distinct lattice constants.

However, even with the polyhydric alcohol used as the organic solvent, the evaporation could not be reduced down to just zero; there was limitation on the long-term maintenance of the properties. In other words, for long-term storage of the colloidal crystal gel set forth in JP(A) 2006-124521, there was a need of allowing it to coexist in an excess of the solvent, giving rise to troublesome handling. With the application of the colloidal crystal gel set forth in JP(A) 2006-124521 to optical devices, there was a need of using a complicated and costly enclosure structure to prevent evaporation of the solvent in the colloidal crystal gel. In addition, with the use of two or more solvents, their ratio changes over time because vapor pressures differ depending on the solvent type. Consequently, there was much difficulty in maintaining the lattice constant of the colloidal crystal gel. To provide easier handling of the colloidal crystal gel and simpler construction of the optical device using the same, it is thus still desired to have a colloidal crystal gel that dispenses with any enclosure structure, and an optical device using the same.

Attention has recently been directed to an ion liquid (also called an ionic liquid) that is an organic salt comprising an anion and an organic cation (for instance, see "Ion Liquids" by Kitazume et. al. Corona Publishing Co., Ltd. ISBN-4-339-06607-9).

However, never until now has there been any attempt to apply the ionic liquid to colloidal crystal gels.

Database WPI Week 200820 Thomson Scientific, London, GB; AN 2008-C70845, JP 2008 046359 A and US 2007/0121193 A1 relate a multicolor display optical composition, an optical device, and a display method of the optical device and particularly to a multicolor display optical composition employing periodic structures, an optical device, and a display method of the optical device. Document US 2007/121193 A1 discloses a multicolour display optical composition, optical device and display method of optical device. Said document discloses a periodic porous structure and does not disclose the combination of ionic liquids with a periodic colloidal crystal gel structure held in place by a polymer.

Document US 2002/164823 A1 discloses a crystalline colloidal array in a swellable hydrogel formed from a methylene-bisacrylamide crosslinked acrylamide. Said document does not disclose the inclusion of ionic liquids.

Document JP 2007 0297421 A discloses a colloidal crystal dispersion with ionic liquids comprising linear polymers grafted to the surface of the periodically arranged particles. Said document does not indicate that the polymers from separate particles are interlinked and therefore the particles are also not "self-organizingly and periodically lined up in a polymer gel".

### SUMMARY OF THE INVENTION

### OBJECTS OF THE INVENTION

The present invention has for its object the provision of a colloidal crystal gel that dispenses with any enclosure structure, its production process, and an optical device using the same.

### MEANS FOR ACHIEVING THE OBJECTS

According to the first aspect of the invention, there is a colloidal crystal gel provided that is characterized in that fine particles are self-organizingly and periodically lined up in a polymer gel, wherein an ion liquid is contained in said polymer according to claim 1. According to the second aspect of the invention, the colloidal crystal gel of the first aspect is further characterized in that said fine particles are lined up in a contact packed state (to be described later).

According to the third aspect of the invention, the colloidal crystal gel of the second aspect is further characterized in that said ion liquid is selected from the group consisting of 1-ethyl-3-methylimidazolium bis(trifluoromethylsulfonyl)imide, trihexyltetradecyl-phosphonium chloride, and trihexyltetradecylphosphonium dicyanamide.

According to the fourth aspect of the invention, the colloidal crystal gel of the first aspect is further characterized in that said fine particles are lined up in a non-contact packed state (to be described later).

According to the fifth aspect of the invention, the colloidal crystal gel of the fourth aspect is further characterized in that said ion liquid is selected from the group consisting of 1-butyl-3-methylimidazolium acetate, 1-ethyl-3-methylimidazolium acetate, 1-hexyl-3-methylimidazolium chloride, 1-methyl-3-octylimidazolium chloride, 1-ethyl-3-methylimidazolium dicyanamide, and 1-butyl-3-methylimidazolium thiocyanate.

According to the sixth aspect of the invention, there is provided a production process for any one of the colloidal crystal gels according to the 1^{st} to 5^{th} aspects of the invention, characterized in that after the fine particles are self-organizingly and periodically lined up, said polymer gel is impregnated with the ion liquid.

According to the seventh aspect of the invention, the process of the 6^{th} aspect is further characterized in that said polymer gel is impregnated with said ion liquid plus a water-containing solvent, followed by removal of the impregnated water.

According to the eighth aspect of the invention, there is provided an optical device using a colloidal crystal gel for control of transmission, reflection and diffraction of light or frequency conversion of light, characterized in that said colloidal crystal gel is any one of the colloidal crystal gels according to the 1^{st} to 5^{th} aspects.

### ADVANTAGES OF THE INVENTION

As set forth in "Ion Liquids" by Kitazume et. al. Corona Publishing Co., Ltd. ISBN-4-339-06607-9, the ion liquid has some features: a vapor pressure of substantially zero, low viscosity in spite of being of ionic nature, heat resistance, and high ion conductivity. The present invention takes advantages of the ion liquid having such features.

By using the ion liquid as recited in the respective aspects of the invention, the inventors could have succeeded in its application to colloidal crystal gels and, consequently, could have solved a long-standing problem with drying.

When the inventive colloidal crystal gel is stored over an extended period of time, and even when that gel is applied to an optical device, there is no need of using any enclosure structure to hold back evaporation of the liquid in the colloidal crystal gel. Consequently, any exclusive enclosure structure for the storage of the inventive colloidal crystal gel as well as for an optical device using the same can be dispensed with, resulting in ease of handle and the provision of an inexpensive optical device for which an existing container may be used as desired. In addition, there are remarkable improvements in the degree of flexibility in optical device design.

The inventive production process for colloidal crystal gels is characterized by embracing the step of impregnating the colloidal crystal gel, in which existing particles are fixed by a gel, with the ion liquid. What is here needed is only the impregnation with the ion liquid, resulting in ease of operation. Any existing equipment is so available that the colloidal crystal gel is provided at low costs.

### BRIEF EXPLANATION OF THE DRAWINGS

Fig. 1 is illustrative in schematic of the inventive colloidal crystal gel 100.
Fig. 2 is illustrative in schematic of the inventive colloidal crystal gel in varying states.
Fig. 3 is a flowchart illustrative of the inventive production of a colloidal crystal gel.
Fig. 4 is a flowchart illustrative of the inventive production of colloidal crystal gels having distinct particle volume fractions.
Fig. 5 is another flowchart illustrative of the inventive production of colloidal crystal gels having distinct particle volume fractions.
Fig. 6 is illustrative in schematic of an optical device using the inventive colloidal crystal gel.
Fig. 7 is illustrative of transmission spectra of Sample 1 of Example 10 before and after exposure to the atmosphere.
Fig. 8 is illustrative of transmission spectra of Sample 10 of Comparative Example 1 before and after exposure to the atmosphere.

Explanation of the Reference Numerals
100, 210, 220, 230: Colloidal Crystal Gel
110: Particles
120: Network Polymer
130: Ion Liquid
600: Optical Device
610, 620, 630: Light

### EMBODIMENTS FOR CARRYING OUT THE INVENTION

Embodiments of the invention are now explained in great detail with reference to the accompanying drawings. It is to be understood that like components are indicated by like numerals, and so will be not explained.

### Embodiment 1

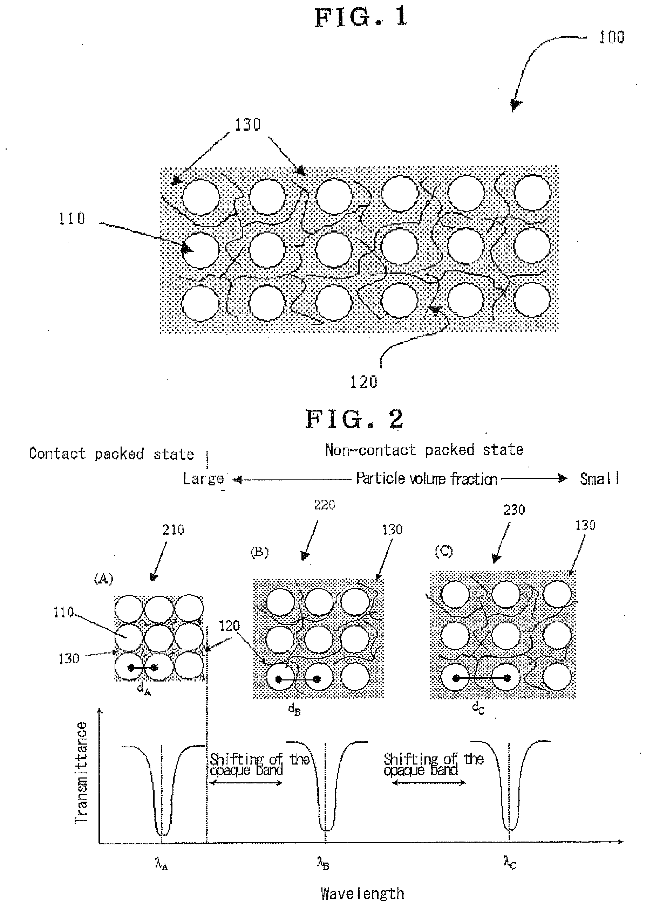

Fig. 1 is illustrative in schematic of the inventive colloidal crystal gel 100.

The inventive colloidal crystal gel 100 is comprised of particles (also called fine particles) 110, network polymer 120 and ion liquid according to claim 1. 138. The term "network polymer containing a liquid medium" here refers to a polymer gel. The liquid medium referred to here is water, an organic solvent, or an ion liquid. As a matter of course, the particles 110 are periodically lined up to form a crystal structure, bringing about Bragg reflection of light on the principles of crystallography.

The particles 110 are also called colloidal particles. By way of example but not by way of limitation, they may be silica particles, polystyrene particles, polymer latex particles, titanium dioxide or other oxide particles, metal particles, or composite particles of different materials used in combination. It is to be noted that the "composite particles" means combinations of two or more different materials. For instance, one material may be encapsulated with another material to form one single particle; one material may be penetrated into another material to form one single particle; and different materials of hemispherical shape may be combined together into one single particle.

The material for the particles 110 may be selected while taking into account a refractive index difference between the particles 110 and the ion liquid 130 to be described later. When there is a large refractive index difference between the particles 110 and the ion liquid 130 (for instance, when polystyrene having a refractive index of 1.59 is selected as the particles 110 and 1-butyl-3-methylimidazolium acetate having a refractive index of 1.49 as the ion liquid 130), there is a colloidal crystal gel obtained that has a large half bandwidth of stop band (opaque band). When there is a small refractive index difference between the particles 110 and the ion liquid 130 (for instance, when silica having a refractive index of 1.46 is selected as the particles 110 and 1-butyl-3-methylimidazolium acetate having a refractive index of 1.49 as the ion liquid 130), there is a colloidal crystal gel obtained that provides a sharp opaque band having a small half bandwidth. Such material choice may be done depending on what the colloidal crystal gel is to be used for.

The network polymer 120 has a three-dimensional network structure created by cross-linking of a polymer formed by polymerization of polymerizable water-soluble molecules (monomer or macromer). The network polymer 120 functions in such a way as to fix and maintain the aforesaid particles 110 in position. By way of example but not by way of limitation, such water-soluble molecules may include acrylamides, and various acrylamide derivatives (e.g., N-methylolmethacrylamide, N-methylolacrylamide, N-acryloisoaminoethoxyethanol, N-acryloisoaminopropanol, and N-isopropylacrylamide). In the present disclosure, it is to be noted that the "network polymer" means the one formed by polymerization of polymerizable water-soluble molecules unless otherwise stated.

The ion liquid 130 functions as a dispersion medium (also called a solvent) instead of water and the organic solvent. The ion liquid 130 does not evaporate off because its vapor pressure is substantially zero. When the inventive colloidal crystal gel 100 is stored or when it is applied to an optical device, there is thus no need of sealing up it in an enclosure structure such as an enclosure container for the purpose of preventing evaporation of the dispersion medium. For reference, typical ion liquids and their properties (melting point, kinematic viscosity, specific gravity, refractive index, miscibility with water, toxicity, etc.) are set out in Table 1. In Table 1, the "complete miscibility" indicates that the ion liquid is very well miscible with water; the "partial miscibility" that the ion liquid may be partially miscible with water although it is poor in miscibility with water; and the "non-miscibility" that the ion liquid is not miscible with water at all.

The properties of various ion liquids are set out in Table 1.

**Table 1**

| Names of the Ion Liquids | Melting Point (°C) | Kinematic viscosity (cSt) | Specific Gravity | Refractive Index |
|---|---|---|---|---|
| (1) | <-20 | 525 | 1.06 | 1.49 |
| (2) | <-20 | 91 | 1.03 | 1.50 |
| (3) | -17 | 18 | 1.52 | 1.42 |
| (4) | -75 | 7,454 | 1.05 | 1.52 |
| (5) | <0 | 16,119 | 1 | 1.51 |
| (6) | -70 | 2,757 | 0.89 | 1.48 |
| (7) | -21 | 17 | 1.08 | 1.51 |
| (8) | -50 | 596 | 0.9 | 1.48 |
| (9) | 11 | 312 | 1.36 | 1.41 |
| (10) | -71 | 233 | 1.12 | 1.42 |
| (11) | -81 | 195 | 1.15 | 1.43 |
| (12) | <-20 | 50.5 | 1.07 | 1.54 |

| Names of the Ion Liquids | Miscibility with water | | HMIS Harmfulness-to-Health Rating | |
|---|---|---|---|---|
| (1) | Complete miscibility | | 0 | |
| (2) | Complete miscibility | | 0 | |
| (3) | Non-Miscibility | | 0 | |
| (4) | Complete miscibility | | 1 | |
| (5) | Complete miscibility | | 2 | |
| (6) | Non-Miscibility | | 3 | |
| (7) | Complete miscibility | | 2 | |
| (8) | Non-Miscibility | | 3 | |
| (9) | Non-Miscibility | | 2 | |
| (10) | Complete miscibility | | NA | |
| (11) | Partial Miscibility | | 1 | |
| (12) | Complete miscibility | | 1 | |

### Names of the Ion Liquids

(1) 1-butyl-3-methylimidazolium acetate
(2) 1-ethyl-3-methylimidazolium acetate
(3) 1-ethyl-3-methylimidazolium bis(trifluoromethylsulfonyl) imide
(4) 1-hexyl-3-methylimidazolium chloride
(5) 1-methyl-3-octylimidazolium chloride
(6) trihexyl-tetradecy-lphosphonium chloride
(7) 1-ethyl-3-methylimidazolium dicyanamide
(8) trihexyl-tetradecyl-phosphonium dicyanamide
(9) 1-butyl-3-methylimidazolium hexafluorophosphate
(10) 1-butyl-3-methylimidazolium tetrafluoroborate
(11) 1-hexyl-3-methylimidazolium tetrafluoroborate
(12) 1-butyl-3-methylimidazolium thiocyanate

As can be seen from Table 1, the ion liquids have a variety of properties. For instance, with an eye set on the HMIS harmfulness-to-health rating, it is preferable to employ an ion liquid having a lower rating under situations where there is concern about influences on human bodies and environments. Although the ion liquid may be selected depending on purposes and the required properties, it is to be understood that the ion liquids set out in Table 1 are given for the purpose of illustration but not by way of limitation.

Various states of the inventive colloidal crystal gel are now explained.

Fig. 2 is illustrative in schematic of the inventive colloidal crystal gel in various states.

Fig. 2(A) is illustrative of the colloidal crystal gel 210 in the contact packed state where the particles contact one another. Figs. 2(B) and 2(C) are illustrative of the colloidal crystal gels 220 and 230 each in the non-contact packed state where the particles do not contact one another.

### (I) Colloidal Crystal Gel in the contact packed state

Fig. 2(A) is illustrative in schematic of the colloidal crystal gel 210 in a close packed state where the particles 110 are lined up while they contact or substantially contact one another. Such a close packed state is called the contact packed state.

Whether or not the colloidal crystal gel is in the contact packed state may be determined from particle volume fractions. When rigid, spherical particles of the same diameter are allowed to contact one another into the closest-packed structure, it has theoretically been known that the particle volume fraction is 74%. However, the practical criterion could be that the particles "substantially contact" one another in the case where the inter-particle distance is up to about 10% larger than that in the theoretically closest-packed state. The particle volume fraction here is about 55%; in other words, a state having a particle volume fraction of 55% or greater could be judged as the contact packed state in the present specification. The upper limit to the particle volume fraction here is not always limited to 74% as long as the ion liquid is contained. This is because the particles could possibly deform and collapse into a close-packed state having a particle volume fraction of 74% or greater. It is to be noted that such a state may appropriately be regarded as the contact packed state too. The particle volume fraction of the colloidal crystal gel impregnated with the ion liquid could easily be determined from a volume change from the starting colloidal crystal gel prior to impregnation with the ion liquid. The particle volume fraction of the starting colloidal crystal gel may be determined from production conditions.

The colloidal crystal gel 210 in the contact packed state has the particles 110 in (substantial) contact with one another, and there is the network polymer 120 positioned in the gaps among them. The ion liquid 130 exits while it penetrates through the network polymer 120. As a result, even at and in the colloidal crystal gel 210 in the contact packed state, the evaporation of the dispersion medium is held back, giving rise to no change in the properties of the colloidal crystal gel 210 due to evaporation.

The ion liquid 130 in the colloidal crystal gel 210 in the contact packed state should preferably be selected from the group consisting of 1-ethyl-3-methylimidazolium bis(trifluoromethylsulfonylimde),trihexyltetradecyl-phosphonium chloride, and trihexyltetradecylphosphonium dicyanamide. These ion liquids are poor in miscibility with water and, hence, poor in affinity for the network polymer 120 comprising a water-soluble molecule, functioning in such a way that the network polymer 120 shrinks.

Such colloidal crystal gel 210 develops a structural color based on the diffraction of light due to the periodic array of the particles 110. By making use of that structural color, the colloidal crystal gel 210 may be applied to coloring materials or sensors. By making use of the effect on confinement of light having a specific frequency and the effect on frequency conversion based on a sophisticated photonic band structure- the nature of the photonic crystal, it may also be applied to a laser device.

As described above, the particles 110 are lined up in the close-packed state so that the colloidal crystal gel 210 is less susceptible of deformation and very stable as well. Accordingly, the colloidal crystal gel 210 in the contact packed state is suited especially for use in environments requiring hardness or rigidity. There is also a little refractive index change due to structural defects such as voids because the ion liquid 130 rather than air remains penetrated through the network polymer 120. Consequently, it is possible to provide an optical device that is more reduced in terms of scattering due to structural defects.

### (II) Colloidal crystal gel in the non-contact packed state

The colloidal crystal gel 220 of Fig. 2(B) and the colloidal crystal gel 230 of Fig. 2(C), that is, the colloidal crystal gels in other states than that of Fig. 2(A) each have the structure having the particles 110 periodically lined up; however, the particles 110 do not contact one another. Such a state is called the non-contact packed state. Whether or not the colloidal crystal gel is in the non-contact packed state may be determined by whether or not the particle volume fraction is below 55%, as described above.

The ion liquid 130 in the colloidal crystal gel 220, 230 in the non-contact packed state should preferably be selected from the group consisting of 1-butyl-3-methylimidazolium acetate, 1-ethyl-3-methylimidazolium acetate, 1-hexyl-3-methylimidazolium chloride, 1-methyl-3-octylimidazolium chloride, 1-ethyl-3-methylimidazolium dicyanamide, and 1-butyl-3-methylimidazolium thiocyanate. These ion liquids are well miscible with water and, hence, has a good affinity for the network polymer 120, functioning in such a way that the network polymer 120 expands.

As shown in Figs. 2(B) and 2(C), the lattice constants (for instance, d_{B}, d_{C}) of the colloidal crystal gels in the non-contact packed state are greater than that (for instance, d_{A}) of the colloidal crystal gel in the contact packed state (d_{B,} d_{C}>d_{A}). In other words, the colloidal crystal gels in the non-contact packed state come to develop the optical characteristics (Bragg wavelength, stop band) in a longer wavelength range that could not be achieved with those in the contact packed state.

As can be seen from Figs. 2(B) and 2(C), the lattice constant d_{B} of the colloidal crystal gel 220 is different from the lattice constant d_{C} of the colloidal crystal gel 230: d_{B}<d_{C}. Such a difference in the lattice constant means that there is a difference in the particle volume fraction. Even the colloidal crystal gels in the non-contact packed state differ in optical characteristics as they differ in particle volume fractions. More specifically, as the lattice constant goes from d_{B} to a wider d_{C} as shown schematically in the lower portion of Fig. 2, it causes the wavelength of the opaque band (i.e., stop band) of transmission spectra to shift from λ_{B} to λ_{C}. According to the invention, it is thus possible to use the ion liquid 130 as the dispersion medium thereby providing colloidal crystal gels having a variety of particle volume fractions (i.e., lattice constants).

The structures of colloidal crystal gels having distinct particle volume fractions are now explained in greater details with reference to Fig. 2. Colloidal crystal gels having distinct particle volume fractions are achievable through (i) a selection or combination of ion liquids, or (ii) control of the amount of the ion liquid to be contained. Each one is now explained with reference to Fig. 2. It is here assumed that the particle volume fraction of the colloidal crystal gel 220 of Fig. 2(B) is greater than that of the colloidal crystal gel 230 of Fig. 2(C).

### (i) Colloidal crystal gels having distinct particle volume fractions, obtained by selection or combination of ion liquids

When the network polymer 120 of a constant weight (minus the solvent) swells with the solvent contained inside, there is the upper limit to the amount of the solvent (dispersion medium) to be contained and held. Accordingly, even when the network polymer coexists with the solvent in an amount beyond the upper limit, there is no increase in the volume of the colloidal crystal gel. Such saturation of the swelling state is called the saturated swelling state, and the amount of the solvent needed for the saturated swelling state to be reached is called the saturated swelling amount. As a matter of course, the colloidal crystal gel in the saturated swelling state will not swell more than that: it has the maximum swelling degree.

However, the saturated swelling amount differs depending on the affinity (swelling capability) of the ion liquid for the network polymer 120. Through an appropriate selection or combination of different ion liquids, therefore, it is possible to obtain colloidal crystal gels having a variety of particle volume fractions by control of the volumes of colloidal crystal gels even in the saturated swelling state.

Suppose here that the colloidal crystal gel 220 of Fig. 2(B) has a larger particle volume fraction and is in the saturated swelling state, and that the colloidal crystal gel 230 of Fig. 2(C) has a relatively smaller particle volume fraction as compared with the colloidal crystal gel 220 and is in the saturated swelling state. The colloidal crystal gel 220 of Fig. 2(B) includes the ion liquid 130 comprised of a combination of ion liquids having lower and higher affinities (or swelling capabilities) for the network polymer 210. On the other hand, the colloidal crystal gel 230 of Fig. 2(C) includes the ion liquid 130 comprised of an ion liquid having a higher affinity (swelling capability) for the network polymer 120 or a combination of ion liquids having lower and higher affinities.

According to the invention, the ion liquid(s) has a vapor pressure of substantially zero so that even when different ion liquids are used in appropriate combinations, there is no change in the mixing ratio of the combinations caused by the evaporation of the dispersion medium, because none of the ion liquids suffers from evaporation. In other words, there is no lattice constant change.

One example of such ion liquid 130 to be selected is 1-butyl-3-methylimidazolium acetate for the colloidal crystal gel 230 of Fig. 2(C).

Referring to one example of the combination and mixing ratio, on the other hand, there is a 9:1 combination of 1-butyl-3-methylimidazolium acetate and 1-ethyl-3-methylimidazolium bis(trifluoromethylsulfonyl) imide for the ion liquid 130 that is to be filled up in the colloidal crystal gel 230 of Fig. 2(C), and a 1:1 combination of 1-butyl-3-metyliniidazolium acetate and 1-ethyl-3-methylimidazolium bis(trifluoromethylsulfonyl) imide for the ion liquid 130 that is to be filled up in the colloidal crystal gel 220 of Fig. 2(B). It is to be noted that such selection and combination is nothing but one example, and modifications to it would be obvious to those skilled in the art. Two or more combinations may be applied.

As a matter of course, and although depending on the selection and combination of the ion liquids 130, it is possible to obtain a colloidal crystal gel in the saturated swelling state that, in terms of particle volume fraction, is larger than the colloidal crystal gel 220 of Fig. 2(B) and smaller than the colloidal crystal gel 210 of Fig. 2(A). It is thus possible to make an appropriate selection and combination of the ion liquid 130 thereby controlling (or tuning) the lattice constant of the colloidal crystal gel as desired.

The ion liquid 130 is different from water and an organic solvent; although depending on the type of the ion liquid 130, it is also possible to obtain a colloidal crystal gel having a particle volume fraction (and, hence, a larger lattice constant) smaller than that of the colloidal crystal gel containing water (or organic solvent) in the saturated swelling amount.

### (ii) Colloidal crystal gels having distinct particle volume fractions, with a controlled amount of the ion liquid to be contained

When the ion liquid 130 to be contained in the colloidal crystal gel is short of the saturated swelling amount, there is a colloidal crystal gel obtained with a particle volume fraction larger than that in the saturated swelling state. Such a colloidal crystal gel is taken as being in an unsaturated swelling state. By carrying out intentional control of the content of the ion liquid, it is thus possible to obtain colloidal crystal gels that are in the unsaturated swelling state and have a variety of particle volume fractions.

Suppose here that the colloidal crystal gel 220 of Fig. 2(B) has a larger particle volume fraction and is in the unsaturated swelling state, and that the colloidal crystal gel 230 of Fig. 2(C) has a smaller particle volume fraction and is in the unsaturated swelling state. Then, the amount of the ion liquid 130 contained in the colloidal crystal gel 220 of Fig. 2(B) is less than that contained in the colloidal crystal gel 230 of Fig. 2(C).

As a matter of course, and although depending how much the ion liquid 130 is short of the saturated swelling amount, it is possible to obtain a colloidal crystal gel whose particle volume fraction is halfway between those of the colloidal crystal gels 220 and 230 or 210 (Fig. 2(A)) and 220. By allowing the ion liquid to be intentionally short of the saturated swelling amount, it is thus possible to control (or tune) the lattice constant of the colloidal crystal gel as desired.

The ion liquid 130 that is to be filled up in the colloidal crystal gel in the unsaturated swelling state should also be selected from the group consisting of 1-butyl-3-methylimidazolium acetate, 1-ethyl-3-methylimidazolium acetate, 1-hexyl-3-methylimidazolium chloride, 1-methyl-3-octylimidazolium chloride, 1-ethyl-3-methylimidazolium dicyanamide, and 1-butyl-3-methylimidazolium thiocyanate. These ion liquids are well miscible with water and, hence, have a good affinity for the network polymer 120, functioning in such a way that the network polymer 120 expands.

In particular, the colloidal crystal gel in the unsaturated swelling state obtained using a conventional volatile solvent was unstable with fluctuations in the lattice constant (i.e., the stop band position) due to the evaporation of the solvent. By use of the ion liquid 130 as the solvent, however, it is possible to obtain a stable colloidal crystal gel in the unsaturated swelling state with no fluctuations in the lattice constant due to the evaporation of the solvent.

It will be readily appreciated that even combinations of (i) and (ii) may result in colloidal crystal gels having distinct particle volume fractions.

It has been explained at great length that by changing the swelling degree of colloidal crystal gels in the non-contact packed state, colloidal crystal gels can be obtained with a variety of lattice constants (stop bands). In what follows, why colloidal crystal gels having a variety of lattice constants are obtained by the deformation of colloidal crystal gels in the non-contact packed state will be explained.

The colloidal crystal gel in the non-contact packed state comes to have gel elasticity (flexibility) by the incorporation of the ion liquid 130 in the network polymer 120. For instance, as compressive stress is applied to the colloidal crystal gel 220, it permits its lattice constant to become small in the compression direction. If the network polymer 120 is temperature-responsible, heating or cooling of the colloidal crystal gel 220 could bring about such a change as shown in Fig. 2: changing of the lattice constant d_{B} to d_{C}.

By taking advantage of these properties, the colloidal crystal gel in the non-contact packed state may be applied to optical sensor devices for pressure, temperature, density (concentration), etc., and optical devices such as tunable spectral devices, laser devices, notch filters and so on. Especially for environments where control (tuning) of optical characteristics in association with lattice constant changes must be implemented on an as-needed basis, the colloidal crystal gel in the non-contact packed state is preferable. As a matter of course, (i) and (ii) may be used in combination with gel elasticity tuning.

In addition to the aforesaid properties, the inventive colloidal crystal gel can also have electric conductivity attributable to the ion liquid 130. Such electrically conductive colloidal crystal gels could have possible applications to light emitter devices, solar cells or the like.

How to produce the inventive colloidal crystal gel is now explained.

### Embodiment 2

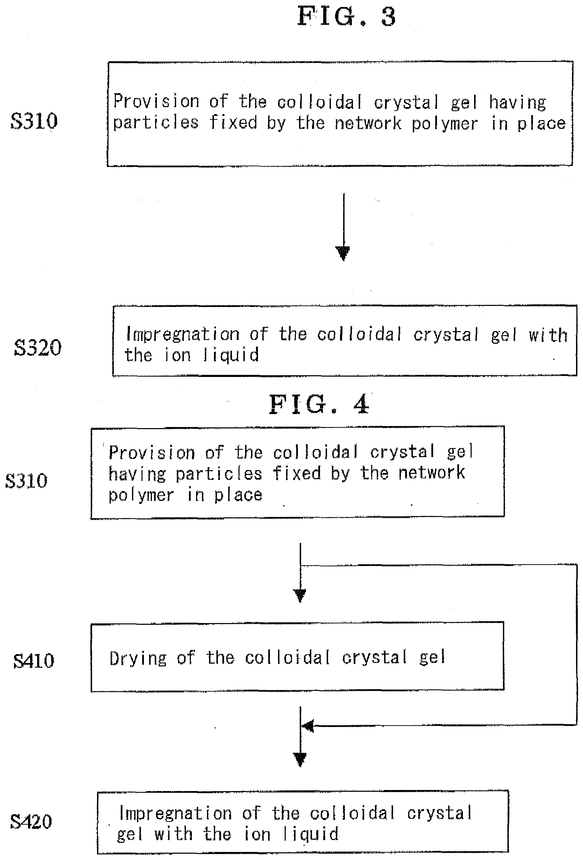

Fig. 3 is a flowchart illustrative of the inventive production of a colloidal crystal gel.

Step S310 : A colloidal crystal gel with the particles 110 fixed by the network polymer 120 in place is provided. The particles 110 and network polymer 120 here are the same as explained in Embodiment 1. In Step S310, the colloidal crystal gel may be either dried or contain a dispersion medium, it is to be noted that any desired conventional dispersion medium such as water or organic solvents, except the ion liquid, may be used to this end. The colloidal crystal gel, for instance, may be prepared pursuant to JP(A) 2006-124521. For convenience of discriminating the inventive colloidal crystal gel from the colloidal crystal gel provided in Step S310, the colloidal crystal gel provided in Step S310 will hereinafter be called the "conventional colloidal crystal gel".

step S320: The conventional colloidal crystal gel is impregnated with the ion liquid 130 that is the same as explained in Embodiment 1. The term "impregnation" here is understood to stand for any desired means for bringing the conventional colloidal crystal gel in contact with the ion liquid 130. For instance, this may be achieved by immersing or dipping the conventional colloidal crystal gel in the ion liquid 130, or adding droplets of the ion liquid 130 down onto the conventional colloidal crystal gel. Typical impregnation conditions involve a holding time of 10 hours to 24 hours at room temperature in atmospheric pressure. According to the inventive process, only the impregnation of the conventional colloidal crystal gel with the ion liquid 130 is thus needed for spontaneous replacement by the ion liquid 130 of the dispersion medium in the conventional colloidal crystal gel. Consequently, the colloidal crystal gel 100 as explained with reference to Embodiment 1 is obtainable.

It is to be noted that from the standpoint of production efficiency, the impregnation in Step S320 may be implemented with the application of heat- When the conventional colloidal crystal gel contains the dispersion medium, this facilitates the volatilization, of the dispersion medium, resulting in accelerated replacement of the dispersion medium by the ion liquid 130. The heating temperature may differ depending on the type of the dispersion medium in the conventional colloidal crystal gel; however, for instance when water is used as the dispersion medium, a temperature range of 40°C to 100°C is preferable because only the dispersion medium can then volatilize off without causing the particles 110 to be out of array.

From the standpoint of production efficiency, the impregnation in Step S320 may be implemented in reduced-pressure or dehumidified atmospheres. When the conventional colloidal crystal gel contains the dispersion medium, this facilitates the volatilization of the dispersion medium, resulting in accelerated replacement of the dispersion medium by the ion liquid 130. Pressure or humidity differs depending on the type of the dispersion medium in the conventional colloidal crystal gel; however, for instance when water is used as the dispersion medium, a reduced-pressure atmosphere of 4 kPa or less or a humidity range of 40% or less is preferred because the effect on accelerated volatilization of the dispersion medium would be much more enhanced than in normal-pressure, normal-humidity atmospheres. As a matter of course in Step S320, the conventional colloidal crystal gel may be heated in reduced-pressure or dehumidified atmospheres.

A preferred process for the production of the colloidal crystal gel 210 (Fig. 2(A)) in the contact packed state, and the colloidal crystal gel 220 (Fig. 2(B)), 230 (Fig. 2(C)) in the non-contact packed state is now explained at great length.

### (I) Process for the production of the colloidal crystal gel in the contact packed state

The process is now explained again with reference to Fig. 3.

Step S310 is followed by Step S320 in which the ion liquid 130 may be selected from the group consisting of 1-ethyl-3-methylimidazolium bis(trifluoromethylsulfonyl) imide, trihexyltetradecylphosphonium chloride, and trihexyltetradecylphosphonium dicyanamide. These ion liquids are poor in affinity for the network polymer 120. Consequently, upon replacement by the ion liquid 130 of the dispersion medium in the conventional colloidal crystal, the network polymer 120 will shrink. In this way, the colloidal crystal gel 210 shown in Fig. 2(A) is obtainable.

### (II) Colloidal crystal gel in the non-contact packed state

(i) Process of producing colloidal crystal gels having distinct particle volume fractions through the selection and combination of ion liquids Reference is once again made to Fig. 3.
   Step S310 is followed by Step S320 in which the ion liquid 130 used is preferably selected from the group consisting of 1-butyl-3-methylimidazolium acetate, 1-ethyl-3-methylimidazolium acetate, 1-hexyl-3-methylimidazolium chloride, 1-methyl-3-octylimidazolium chloride, 1-ethyl-3-methylimidazolium dicyanamide, and 1-butyl-3-methylimidazolium thiocyanate.
   These ion liquids are well miscible with water and, hence, have a high affinity (swelling capability) for the network polymer 120, providing the colloidal crystal gel 220 or 230 with a small particle volume fraction, as shown in Fig. 2(B) or 2(C). However, the quantitative value of the particle volume fraction obtained changes depending on the type/combination of the ion liquids to be selected; it is possible to obtain colloidal crystal gels having a variety of interim particle volume fractions. Furthermore, even with combinations of the ion liquids coming within the above group having a high miscibility with water and the ion liquids referred to at (I) and having a low miscibility with water, it is likewise possible to obtain colloidal crystal gels having interim particle volume fractions.
   It is to be noted that as explained in detail with reference to Embodiment 1, such selection and combination of the ion liquids 130 may be made depending on the particle volume fraction of the end colloidal crystal gel.
(ii) Process of producing colloidal crystal gels having distinct particle volume fractions with a controlled amount of the ion liquid to be contained

Fig. 4 is a flowchart illustrative of the inventive production of colloidal crystal gels having distinct particle volume fractions.

Step S310: The explanation of this step is left out because of being the same as that of Step S310 of Fig. 3.

Step S410: When the dispersion medium in the conventional colloidal crystal gel provided in Step S310 is a volatile solvent such as water or an organic solvent, the conventional colloidal crystal gel is dried. For drying here, the conventional colloidal crystal gel may be exposed to a reduced-pressure or dehumidified atmosphere with the application of heat to it. It is to be noted that the conditions for heating and reduced-pressure or dehumidified atmosphere are much the same as described above.

Step S420: As in Step S320 of Fig. 3, the dried colloidal crystal gel is impregnated with the ion liquid 130. In this case too, the ion liquid 130 is selected from the group referred to at (i) ; however, the ion liquid 130 is set at any desired amount less than the saturated swelling amount or, alternatively, the impregnation is appropriately intermitted before the colloidal crystal gel reaches the saturated swelling state. This in turn allows the amount of the impregnating ion liquid to be controlled to the saturated swelling amount so that colloidal crystal gels in a variety of unsaturated swelling states, that is, those having a variety of particle volume fractions (lattice constants) can be obtained.

For instance when it is intended to obtain the colloidal crystal gel 220 having such a large particle volume fraction as in Fig. 2(B), the dried conventional colloidal crystal gel may be impregnated with the ion liquid 130 in an amount less than the saturated swelling amount- It is to be noted that if relations between various ion liquids and their saturated (unsaturated) swelling amounts are figured out beforehand, the pickup (impregnation amount) may be readily determined from them.

It is to be noted that when the conventional colloidal crystal gel is already dried in Step S310, it may be sent to Step S420 not via Step S410.

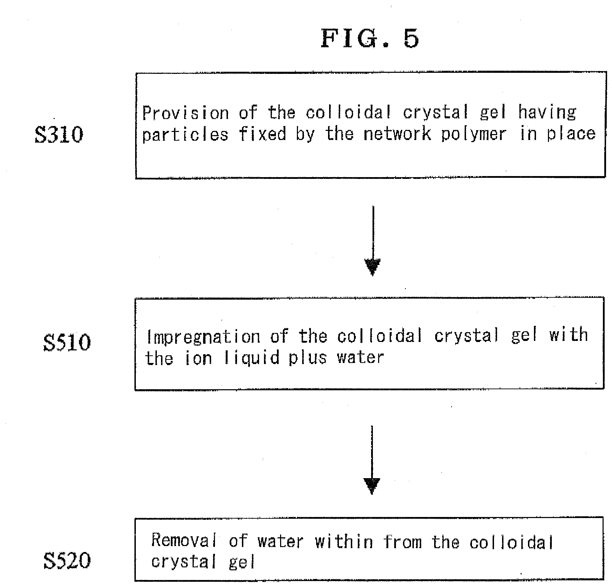

Fig. 5 is another flowchart illustrative of the inventive production of colloidal crystal gels having distinct particle volume fractions.

Step S310: The explanation of this step is left out because of being much the same as that of Step S310 of Fig. 3.

Step S510: This step is much the same as Step S320 of Fig. 3 except that the ion liquid 130 is used with water added to it. That is, the conventional colloidal crystal gel is impregnated with a dispersion medium in which the ion liquid 130 and water are mixed together at a given ratio. The given ratio differs depending on the desired particle volume fraction (lattice constant): more water would result in a colloidal crystal gel having a larger particle volume fraction, and less water would result in a colloidal crystal gel having a smaller particle volume fraction. It is to be noted that if relations between various ion liquids and their saturated (unsaturated) swelling amounts are figured out beforehand, the ratio of such an ion liquid to water may be readily determined from them. In Step S510, there is a colloidal crystal gel obtained that comprises the ion liquid 130 and water at the given ratio and is impregnated in the saturated welling amount, In this case too, the ion liquid 130 is selected from the group referred to at (i).

Step S520: In this step, water is removed from within the colloidal crystal gel obtained in Step S510 and impregnated with the ion liquid 130 and water. Water removal may be carried out as in Step S410 of Fig. 4. This in turn allows the pickup of the ion liquid to be set at the controlled unsaturated swelling amount, yielding colloidal crystal gels in a variety of unsaturated swelling states, that is, those having a variety of particle volume fractions (lattice constants).

It is to be noted that although Step S510 have been explained exclusively with reference to water, other volatile organic solvents may be used too; however, preference is given to water from the standpoints of ease of availableness, and ease of removal in Step S520.

To obtain a colloidal crystal gel whose particle volume fraction is controlled with precision, the colloidal crystal gel provided in Step S310 should be already dried or, alternatively, the conventional colloidal crystal gel should be dried after Step S310 and prior to Step S510 (i.e., Step S410 of Fig. 4).

### Embodiment 3

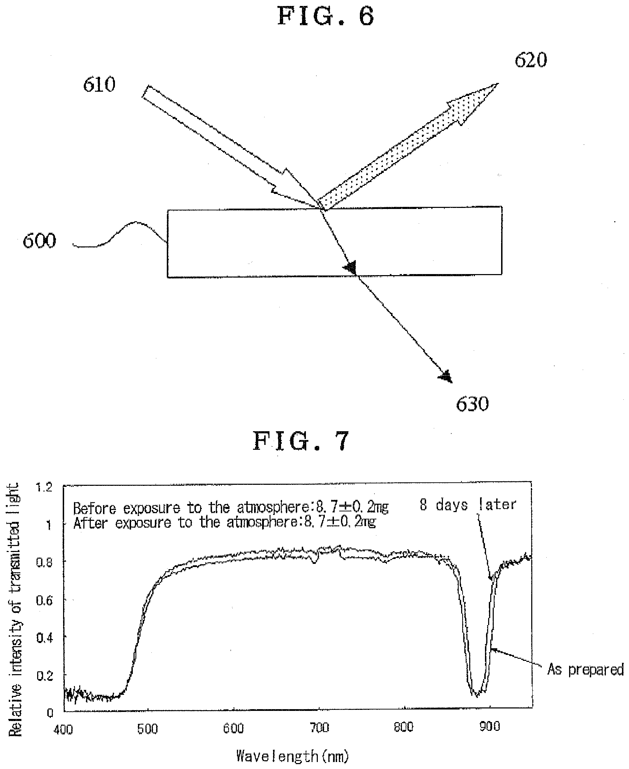

Fig. 6 is illustrative in schematic of an optical device using the inventive colloidal crystal gel.

The optical device 600 functions as a notch filter. The optical device 600 makes use of the colloidal crystal gel explained with reference to Embodiment 1. More specifically, the optical device 600 makes use of the colloidal crystal gel 230 (Fig. 2) in the non-contact packed state. The colloidal crystal gel 230 has a stop band with a wavelength λ_{C} as center. The colloidal crystal gel 230 is located typically on a glass substrate. The colloidal crystal gel 230 need not be sealed up in an enclosure container to prevent evaporation because, as already explained with reference to Embodiment 1, the dispersion medium contained in it is the ion liquid 130 (Fig. 1 and 2).

The operation of the notch filter using the optical device 600 is now explained.

Light 610 having at least the wavelength λ_{C} enters the optical device 600. As described above, the colloidal crystal gel 230 that forms part of the optical device 600 has a lattice constant indicated by d_{C} and a stop band with the wavelength λ_{C} as center; light 610 entering the optical device 600 travels and arrives at the colloidal crystal gel 230 at which only light 620 having a narrow wavelength width with the wavelength λ_{C} as center is reflected. On the other hand, light 630 having a wavelength outside the narrow wavelength width with the wavelength λ_{C} as center travels through the colloidal crystal gel 230, leaving the optical device 600. Only light having a very narrow bandwidth (here light 620 having a narrow wavelength width with the wavelength λ_{C} as center) can thus be reflected/cut off.

It is to be noted that although the notch filter making use of single one colloidal crystal gel in the non-contact packed state has been exemplified in Embodiment 3, yet the invention is by no means limited to it- For instance, a similar notch filter may be built up of a plurality of colloidal crystal gels differing in the particle volume fraction.

As a matter of course, the use of the inventive colloidal crystal gel is never limited to notch filters: it may be applicable to coloring materials, chemical sensors and distortion sensors each harnessing the structural color of the colloidal crystal gel as well as spectral devices, laser devices and other optical devices, each harnessing the stop band of the colloidal crystal gel. In particular, the colloidal crystal gel in the non-contact packed state has the aforesaid optical characteristics plus ease of deformation due to the fact that the particles do not contact one another, and so it is suitable for applications needing wavelength tunability.

While the invention is now explained in further details with reference to specific examples, it is to be understood that the invention is never limited to them.

### Example 1

A conventional colloidal crystal gel was provided (Step S310) of Fig. 3. More specifically, a particle dispersion liquid (Model 5020B made by Duke Scientific Co., Ltd.), in which polystyrene particles (of 200 nm in particle diameter) were dispersed as the particles 110 in water, was regulated to a particle volume fraction of about 16%, and an ion exchange resin (Model AG501-X8 made by Bio-Rad Co., Ltd.) was charged in it for desalting, thereby obtaining a dispersion liquid in a colloidal crystal state. Then, the dispersion liquid and a gelling solution were mixed together at an 8:2 proportion to obtain a reaction solution. It is to be noted that the gelling solution is an aqueous solution containing 30 wt% of N-methylolacrylamide (N-MAM) as a polymerizing monomer, 3 wt% of N,N'-methylenebisacrylamide (Bis) as a crosslinking agent and a polymerization initiator (azobis[2-metbyl-N(2-hydroxyethyl)propionamide]) at a concentration of 0.5 mg/mL. By irradiation with ultraviolet radiation, these are polymerised into the network polymer 12 0.

Then, the obtained reaction solution was formed into a conventional monocrystalline colloidal crystal gel of 0.1 mm in thickness according to the method set forth in JP(A) 2006-124521. The conventional colloidal crystal gel in a film form was cut into a round sample piece of 7 mmφ in diameter. It is to be noted that the cut round sample piece is being immersed and swollen in water. It is also to be noted that the saturated swelling amount of water in the round sample piece was about 3 µL.

After that, the round sample piece was impregnated with the ion liquid: 1-butyl-3-methylimidazolium acetate (Step S320 of Fig. 3). The impregnation was carried out by immersing the round sample piece in the above ion liquid in an amount, of about 100 µL for 24 hours. Immediately after the immersion, size changes were visually observed in the round sample piece. This is because water in the round sample piece was replaced by the ion liquid. It is to be noted that such size changes were stabilized by an about 20-hours immersion. The round sample piece impregnated with the ion liquid in this way is called Sample 1.

Sample 1 was measured for its particle volume fraction. The diameter of Sample 1 was first measured, and then divided by the diameter (7 mmφ) of the round sample piece comprised of the colloidal crystal gel with water used as the dispersion medium to find out the coefficient of expansion. Assume here that the size changes are isotropic (meaning that the coefficient of expansion is equal in both thickness and diametrical directions). Then, the particle volume fraction in the state impregnated with the ion liquid was figured out from the particle volume fraction (13%) in the initial state swollen with water. The results are set out in Table 2.

Then, Sample 1 was measured for its transmission spectra to find out the longest Bragg wavelength. For the measurement, a plane spectrophotometer; ImSpector V10 made by Kawasaki Steel Techno-research Corp., Chiba, Japan was used. The results are set out in Table 2.

### Example 2

Example 1 was repeated with the exception that 1-ethyl-3-methylimidazolium acetate instead of 1-butyl-3-methylimidazolium acetate was used as the ion liquid. The obtained round sample piece impregnated with the ion liquid is called Sample 2. As in Example 1, the coefficient of expansion, particle volume fraction and longest Bragg wavelength of Sample 2 were found. The results are set out in Table 2.

### Example 3

Example 1 was repeated with the exception that 1-hexyl-3-methylimidazolium chloride instead of 1-butyl-3-methylimidazolium acetate was used as the ion liquid. The obtained round sample piece impregnated with the ion liquid is called Sample 3. As in Example 1, the coefficient of expansion, particle volume fraction and longest Bragg wavelength of Sample 3 were found. The results are set out in Table 2.

### Example 4

Example 1 was repeated with the exception that 1-metyl-3-octylimidazolium chloride instead of 1-butyl-3-methylimidazolium acetate was used as the ion liquid. The obtained round sample piece impregnated with the ion liquid is called Sample 4. As in Example 1, the coefficient of expansion, particle volume fraction and longest Bragg wavelength of Sample 4 were found. The results are set out in Table 2.

### Example 5

Example 1 was repeated with the exception that 1-ethyl-3-methylimidazolium dicyanamide instead of 1-butyl-3-methylimidazolium acetate was used as the ion liquid. The obtained round sample piece impregnated with the ion liquid is called Sample 5. As in Example 1, the coefficient of expansion, particle volume fraction and longest Bragg wavelength of Sample 5 were found. The results are set out in Table 2.

### Example 6

Example 1 was repeated with the exception that 1-butyl-3-methylimidazolium thiocyanate instead of 1-butyl-3-methylimidazolium acetate was used as the ion liquid. The obtained round sample piece impregnated with the ion liquid is called Sample 6. As in Example 1, the coefficient of expansion, particle volume fraction and longest Bragg wavelength of Sample 6 were found. The results are set out in Table 2.

### Example 7

Example 1 was repeated with the exception that 1-ethyl-3-methylimidazolium bis(trifluoromethylsulfonyl) imide instead of 1-butyl-3-methylimidazolium acetate was used as the ion liquid. The obtained round sample piece impregnated with the ion liquid is called Sample 7. As in Example 1, the coefficient of expansion, particle volume fraction and longest Bragg wavelength of Sample 7 were found. The results are set out in Table 2.

### Example 8

Example 1 was repeated with the exception that trihexyltetradecylposphonium chloride instead of 1-butyl-3-methylimidazolium acetate was used as the ion liquid. The obtained round sample piece impregnated with the ion liquid is called Sample 8. As in Example 1, the coefficient of expansion, particle volume fraction and longest Bragg wavelength of Sample 8 were found. The results are set out in Table 2.

### Example 9

Example 1 was repeated with the exception that trihexyltetradecylposphonium dicyanamide instead of 1-butyl-3-methylimidazolium acetate was used as the ion liquid. The obtained round sample piece impregnated with the ion liquid is called Sample 9. As in Example 1, the coefficient of expansion, particle volume fraction and longest Bragg wavelength of Sample 9 were found. The results are set out in Table 2.

In Table 2, the miscibility with water of the ion liquid used in each of Examples 1 to 9 is also shown. In Table 2, Symbol ○ indicates that the ion liquid is full miscible with water, and X indicates that it does not (poor in miscibility with water).

In Table 2, the types of the ion liquids in Examples 1 to 9 are also shown together with the properties of the colloidal crystal gels.

**Table 2**

| Example No./sample No. | Type of the Ion Liquids | Miscibility of the Ion Liquids with water | Coefficient of expansion of the samples | Particle Volume Fraction (%) of the samples | Longest Bragg Wavelength (nm) of the samples |
|---|---|---|---|---|---|
| 1 | (A) | ○ | 1.06 | 11±3 | 886 |
| 2 | (B) | ○ | 0.99 | 14±4 | 854 |
| 3 | (C) | ○ | 1.01 | 13±4 | 917 |
| 4 | (D) | ○ | 0.92 | 17±5 | 817 |
| 5 | (E) | ○ | 0.95 | 16±4 | 840 |
| 6 | (F) | ○ | 0.82 | 25±7 | 745 |
| 7 | (G) | × | <0.6 | >62 | - |
| 8 | (H) | × | <0.6 | >62 | - |
| 9 | (I) | × | <0.6 | >62 | - |

(A): 1-butyl-3-methylimidazolium acetate
(B): 1-ethyl-3-methylimidazolium acetate
(C): 1-hexyl-3-methylimidazolium chloride
(D): 1-methyl-3-octylimidazolium chloride
(E): 1-ethyl-3-methylimidazolium dicyanamide
(F): 1-butyl-3-methylimidazolium thiocyanate
(G): 1-ethyl-3-methylimidazolium bis(trifluoromethylsulfonyl)imide
(H): trihexyl-tetradecyl-phosphonium chloride
(I): trihexyl-tetradecyl-phosphonium dicyanamide

From the fact that Samples 1 to 6 (Examples 1 to 6) using the ion liquids full miscible with water each had a particle volume fraction of 10% to 25%, it has been appreciated that Samples 1 to 6 are all colloidal crystal gels in the non-contact packed state.

On the other hand, Samples 7 to 9 (Examples 7 to 9) using the ion liquids poor in miscibility with water each had a particle volume fraction greater than 62%. Visual observation of Samples 7 to 9 has revealed that they are all transparent with the ion liquids contained in them. From this, it has been appreciated that Samples 7 to 9 are all colloidal crystal gels in the contact packed state.

From the foregoing, it has been ascertained that the ion liquids well miscible with water are preferable for the purpose of obtaining colloidal crystal gels in the non-contact packed state, whereas the ion liquids poor in miscibility with water are preferable for the purpose of obtaining colloidal crystal gels in the contact packed state.

From the longest Bragg wavelength of each of Samples 1 to 6, it has been appreciated that there is a difference in the longest Bragg wavelength, i.e., the lattice constant depending on the type of the ion liquid used. This implies that the colloidal crystal gels in the non-contact packed state, exemplified by Samples 1 to 6, differ in the particle volume fraction. It has thus been understood that by an appropriate selection of ion liquids, colloidal crystal gels having distinct particle volume fractions can be obtained.

From the coefficients of expansion for Samples 1 and 3 in particular, it has been appreciated that there can be colloidal crystal gels obtained whose particle volume fractions are much smaller than that of the colloidal crystal gel (conventional colloidal crystal gel) using water as the dispersion medium. This indicates that although depending on the ion liquid to be selected, yet the inventive colloidal crystal gel is well compatible with a long wavelength range that could not been achieved with the conventional colloidal crystal gel.

### Example 10

Sample 1 obtained in Example 1 was placed on a slide glass, and an excess of the ion liquid was removed through a filter paper. After that, Sample 1 on the slide glass was held for 8 days while remaining open to the atmosphere. The weight and transmission spectra of Sample 1 before and after exposure to the atmosphere were measured. The results depicted in Fig. 7 will be explained in detail.

### Comparative Example 1

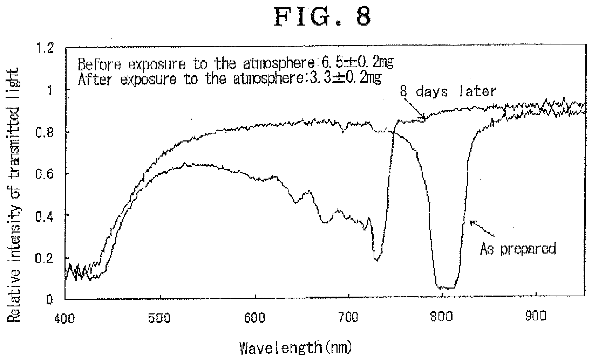

Example 1 was repeated with the exception that ethylene glycol instead of the ion liquid: 1-butyl-3-methylimidazolium acetate was used as the dispersion medium. The obtained round sample piece impregnated with ethylene glycol is here called Sample 10. As in Example 10, Sample 10 was exposed to the atmosphere for 8 days. The weight and transmission spectra of Sample 10 before and after exposure to the atmosphere were measured. The results depicted in Fig. 8 will be explained in detail.

Fig. 7 is illustrative of the transmission spectra of Sample 1 in Example 10 before and after exposure to the atmosphere.

Fig. 8 is illustrative of the transmission spectra of Sample 10 in Comparative Example 1 before and after exposure to the atmosphere.

As can be seen from Fig. 7, with the ion liquid used as the dispersion medium, there was no change in the transmission spectra observed even when the colloidal crystal gel (Sample 1) was exposed to the atmosphere for 8 days. Likewise, there was no weight change of Sample 1 even upon exposed to the atmosphere for 8 days.

As can be seen from Fig. 8, on the other hand, the use of ethylene glycol as the dispersion medium caused the transmission spectra shape to become out of order and the minimum value of the opaque band to be clearly shifted after an 8-day exposure of the colloidal crystal gel to the atmosphere. The 8-day exposure to the atmosphere caused Sample 10 to decrease to half in weight.

As expounded above, the inventive colloidal crystal gel makes use of the ion liquid as the dispersion medium, thereby keeping the dispersion medium from evaporation. Consequently, there are none of changes in the optical characteristics such as transmission spectra due to evaporation; even when the inventive colloidal crystal gel is applied to an optical device or the like, it need not be encased in any special enclosure structure.

### APPLICABILITIES TO THE INDUSTRY

The liquid-impregnated colloidal crystal gel according to the invention is characterized in that the ion liquid is used as that liquid. The ion liquid, because of no substantial vapor pressure, does not evaporate off. For this reason, any enclosure structure is not needed for the inventive colloidal crystal gel. Such colloidal crystal gels may find applications to coloring materials, and optical devices such as chemical sensors, distortion sensors, notch filters, spectroscopic devices and laser devices. In particular, the colloidal crystal gels in the non-contact packed state are best suited for some applications needing wavelength tunability. The inventive colloidal crystal gel could have potential applications to light emitter devices and solar cells as well, because of having the aforesaid characteristics plus electrical conductivity. The inventive colloidal crystal gel is also improved in terms to resistance to environments because the dispersion medium used is the ion liquid that does not evaporate off not only under the atmosphere but also in special environments such as a high-temperature, high-vacuum one.

## Claims

1. A colloidal crystal gel, **characterized in that** fine particles are self-organizingly and periodically lined up in a polymer gel, wherein the polymer gel comprises a network polymer containing an ion liquid,
wherein the network polymer has a three-dimensional network structure created by cross-linking of a polymer formed by polymerization of polymerizable water-soluble molecules, and
wherein the network polymer fixes and maintains the periodically lined-up fine particles in position.

2. A colloidal crystal gel as recited in claim 1, **characterized in that** said fine particles are lined-up in the contact packed state.

3. A colloidal crystal gel as recited in claim 2, **characterized in that** said ion liquid is selected from the group consisting of 1-ethyl-3-methylimidazolium bis(trifluoromethylsulfonyl)imide, trihexyltetradecyl-phosphonium chloride, and trihexyltetradecylphosphonium dicyanamide.

4. A colloidal crystal gel as recited in claim 1, **characterized in that** said fine particles are lined up in the non-contact packed state.

5. A colloidal crystal gel as recited in claim 4, **characterized in that** said ion liquid is selected from the group consisting of 1-butyl-3-methylimidazolium acetate, 1-ethyl-3-methylimidazolium acetate, 1-hexyl-3-methylimidazolium chloride, 1-methyl-3-octylimidazolium chloride, 1-ethyl-3-methylimidazolium dicyanamide, and 1-butyl-3-methylimidazolium thiocyanate.

6. A process of producing a colloidal crystal gel as recited in any one of claims 1 to 5, **characterized in that** after the fine particles are self-organizingly and periodically lined up and fixed by the polymer gel, said polymer gel is impregnated with the ion liquid.

7. A process as recited in claim 6, **characterized in that** said polymer gel is impregnated with said ion liquid plus a water-containing solvent, followed by removal of said impregnated water.

8. An optical device comprising a colloidal crystal gel, **characterized in that** said colloidal crystal gel is configured to be used for control of transmission, reflection and diffraction of light or frequency conversion of light, wherein said colloidal crystal gel is a colloidal crystal gel as recited in any one of claims 1 to 5.

## Patentansprüche

1. Ein kolloidales Kristallgel, **dadurch gekennzeichnet, dass** Feinpartikel selbstorganisierend und periodisch in einem Polymergel aufgereiht sind, wobei das Polymergel ein eine Ionenflüssigkeit enthaltendes Netzwerkpolymer umfasst,
wobei das Netzwerkpolymer eine dreidimensionale Netzwerkstruktur aufweist, die durch Vernetzung eines durch Polymerisation von polymerisierbaren wasserlöslichen Molekülen gebildeten Polymers gebildet ist, und
wobei das Netzwerkpolymer die periodisch aneinandergereihten feinen Partikel in Position fixiert und hält.

2. Kolloidales Kristallgel nach Anspruch 1, **dadurch gekennzeichnet, dass** die Feinpartikel im Kontaktfüllzustand aufgereiht sind.

3. Kolloidales Kristallgel nach Anspruch 2, **dadurch gekennzeichnet, dass** die Ionenflüssigkeit ausgewählt ist aus der Gruppe bestehend aus 1-Ethyl-3-methylimidazolium-bis (trifluormethylsulfonyl)-imid, trihexyltetradecylphosphoniumchlorid und Trihexyltetradecylphosphoniumdicyanamid.

4. Kolloidales Kristallgel nach Anspruch 1, **dadurch gekennzeichnet, dass** die Feinpartikel im kontaktfreien Füllzustand aufgereiht sind.

5. Kolloidales Kristallgel nach Anspruch 4, **dadurch gekennzeichnet, dass** die Ionenflüssigkeit ausgewählt ist aus der Gruppe bestehend aus 1-Butyl-3-methylimidazoliumacetat, 1-Ethyl-3-methylimidazoliumacetat, 1-Hexyl-3-methylimidazoliumchlorid, 1-Methyl-3-octylimidazoliumchlorid, 1-Ethyl-3-methylimidazoliumdicyanamid und 1-Butyl-3-methylimidazoliumthiocyanat.

6. Verfahren zur Herstellung eines kolloidalen Kristallgels nach einem der Ansprüche 1 bis 5, **dadurch gekennzeichnet, dass** nachdem die Feinpartikel selbstorganisierend und periodisch aufgereiht und von dem Polymergel fixiert sind, das Polymergel mit der Ionenflüssigkeit imprägniert wird.

7. Verfahren nach Anspruch 6, **dadurch gekennzeichnet, dass** das Polymergel mit der Ionenflüssigkeit sowie einem wasserhaltigen Lösungsmittel imprägniert wird, wobei anschließend die Entfernung des imprägnierten Wassers erfolgt.

8. Eine optische Vorrichtung mit einem kolloidalen Kristallgel, **dadurch gekennzeichnet, dass** das kolloidale Kristallgel konfiguriert ist, um zur Steuerung der Übertragung, Reflexion und Beugung von Licht oder zur Frequenzkonversion von Licht verwendet zu werden, wobei das kolloidale Kristallgel ein kolloidales Kristallgel nach einem der Ansprüche 1 bis 5 ist.

## Revendications

1. Gel cristallin colloïdal, **caractérisé en ce que** des particules fines sont auto-organisées et périodiquement orientées dans un gel polymère, ledit gel polymère comprenant un polymère réticulé contenant un liquide ionique,
où le polymère réticulé a une structure de réseau tridimensionnel créée par réticulation d'un polymère formé par polymérisation de molécules polymérisables solubles dans l'eau, et
où le polymère réticulé fixe et maintient en position les particules fines périodiquement orientées.

2. Gel cristallin colloïdal selon la revendication 1, **caractérisé en ce que** les particules fines sont orientées en état de serrage avec contact.

3. Gel cristallin colloïdal selon la revendication 2, **caractérisé en ce que** le liquide ionique est sélectionné dans le groupe comprenant 1-éthyl-3-méthylimidazolium bis(trifluorométhylsulfonyl)imide, chlorure de trihexyltétradecyl-phosphonium, et tri-hexyltétradécylphosphonium dicyanamide.

4. Gel cristallin colloïdal selon la revendication 1, **caractérisé en ce que** les particules fines sont orientées en état de non-serrage avec contact.

5. Gel cristallin colloïdal selon la revendication 4, **caractérisé en ce que** le liquide ionique est sélectionné dans le groupe comprenant 1-butyl-3-méthylimidazolium acétate, 1-éthyl-3-méthylimidazolium acétate, chlorure de 1-hexyl-3-méthylimidazolium, chlorure de 1-méthyl-3-octylimidazolium, 1-éthyl-3-méthylimidazolium dicyanamide, et 1-butyl-3-méthylimidazolium thiocyanate.

6. Procédé de production d'un gel cristallin colloïdal selon l'une des revendications 1 à 5, **caractérisé en ce qu'**après auto-organisation, orientation périodique des particules fines et fixation de celles-ci par le gel polymère, ledit gel polymère est imprégné par le liquide ionique.

7. Procédé selon la revendication 6, **caractérisé en ce que** le gel polymère est imprégné par le liquide ionique plus un solvant à teneur en eau, l'eau d'imprégnation étant retirée à la suite.

8. Dispositif optique comprenant un gel cristallin colloïdal, **caractérisé en ce que** ledit gel cristallin colloïdal est destiné à être utilisé pour une commande de transmission, de réflexion et de diffraction de lumière ou une conversion de fréquence lumineuse, ledit gel cristallin colloïdal étant un gel cristallin colloïdal selon l'une des revendications 1 à 5.
